Europäisches Patentamt

European Patent Office

Office européen des brevets

(11) Publication number: **0 070 692**
A2

## (12) EUROPEAN PATENT APPLICATION

(21) Application number: **82303718.9**

(22) Date of filing: **15.07.82**

(51) Int. Cl.³: **H 01 L 21/56,** H 01 L 21/268, H 01 L 21/76

(30) Priority: **17.07.81 GB 8122176**

(43) Date of publication of application: **26.01.83** Bulletin 83/4

(84) Designated Contracting States: **CH DE FR IT LI NL**

(71) Applicant: **WESTINGHOUSE BRAKE AND SIGNAL COMPANY LIMITED, Foundry Lane, Chippenham Wiltshire SN15 1RT (GB)**

(72) Inventor: **Wood, Michael John, Foundry Lane, Chippenham Wiltshire (GB)**

(74) Representative: **Page, Edmund John, Temple Gate House Temple Gate, Bristol BS1 6PL (GB)**

(54) Semiconductor device passivation.

(57) A method of semiconductor device passivation in which a passivation moat (5/6) is formed initially, at least, by cutting with a laser beam. The moat is preferably finished to its final dimensions by chemical etching. To trace out the path of the moat either the device may be moved relative to a stationary laser beam or the laser beam may be moved relative to a stationary device.

Semiconductor Device Passivation

The invention relates to semiconductor device passivation.

Passivation by the application of a layer of dielectric material to the periphery of the active junction of a semiconductor device is a well established technique of stabilising the dynamic operating characteristics of the device. The dielectric is applied as a coating on the surface of a moat cut into the semiconductor body from one or both major faces.

In devices having chemically etched moats the walls of the moats intersect the high voltage junction plane at an unsuitable angle for maximising voltage blocking capability and as a result breakdown of the device occurs prematurely. An improvement is found in devices in which the edge of the device in this region has a suitably chamfered profile with a double positive bevel, such a device is described in G.B. Patent No. 1 211 627.

Double positive bevel techniques are generally incompatible with production processes in which a plurality of devices are formed on a single semiconductor slice since they require the slice to be separated into individual pellets. Furthermore existing moat etching techniques whilst compatible with multi-device slice manufacture do not provide the edge profiles preferred for high voltage characteristics.

The present invention seeks to provide a method of semiconductor device passivation which will produce the preferred edge profile for high voltage devices and be suitable application to semiconductor slices upon which a plurality of devices are simultaneously formed.

According to the invention there is provided a method of semiconductor device passivation in which a moat adjacent the perimeter of the active region of the devices is coated with passivating dielectric material characterised by a step of forming the moat by cutting by means of a laser beam incident at an oblique angle with respect to the surface of an active region of the device.

Preferably the method includes the further step of enlarging the laser cut moat by chemical etching to the required dimensions of breadth and depth.

The invention and how it may be carried into practice will now be described in greater detail, by way of example only, with reference to the accompanying drawing, in which:

Fig. 1 is a sectional view showing an abliquely cut moat for a semiconductor diode,

Fig. 2 is a similar view to Fig. 1 in which the dimensions of the moat have been enlarged by etching,

Fig. 3 is a plan view showing several diodes on a single slice and the positions of their respective moats,

Fig. 4 is a sectional view of part of a slice showing the obliquely cut and etched moats of a thyristor, and

Fig. 5 is a similar view of a thyristor in which the reverse blocking junction is shorted internally to the forward blocking junction.

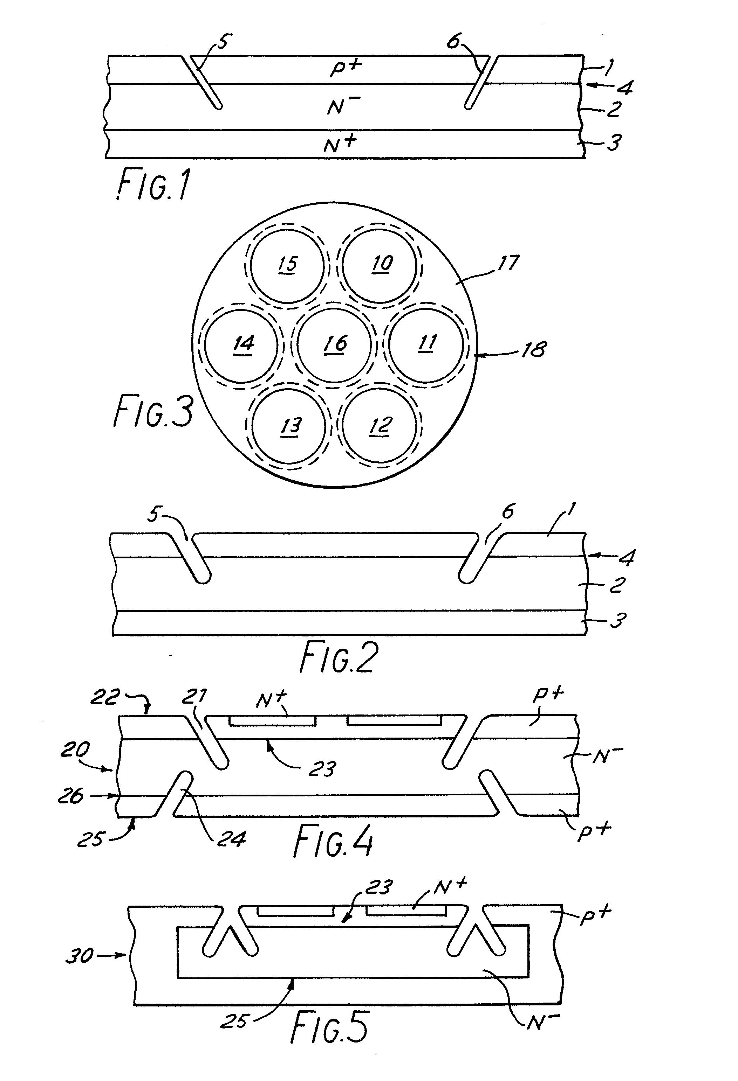

Referring now to Fig. 1 there is shown a sectional view through semiconductor diode consisting of three superimposed semiconductor layers 1, 2 and 3 of $p^+$, $N^-$ and $N^+$ conductivity respectively, in which the junction between layers 1 and 2 is the active diode junction generally indicated at 4.

According to a conventional moat etch passivation process a moat having angled sides is etched downwardly from the upper exposed surface of the $p^+$ layer 1, through the junction to a depth approximately halfway into the $N^-$ layer 2. The exposed surfaces of the moat are then coated with a passivating dielectric material glass, a chemical vapour deposited film, resin or rubber at least partially filling the moat. The angle of inter-section of the walls of the moat with the diode junction 4 does not provide the best edge profile of the junction for high voltage operation. The problem being that a chemical etch mixture is directionally non-preferential so that the resulting moat tends to be as wide at the mouth as it is deep.

According to the invention a moat is cut initially by means of an obliquely angled laser beam thus producing the moat profile shown at 5 and 6 in Fig. 1. This initial laser cut extends to substantially the full moat depth but is somewhat narrower than the required final width of the moat. The inner or obliquely angled wall 7 of the moat can be arranged to provide the preferred chamfer angle at the edge of the active diode junction by corresponding orientation of the laser beam during the initial cutting step. In a second stage the moat is etched out to its final dimensions, as shown in Fig. 2, using a conventional etch solution. This removes all the silicon damaged by the laser beam but because much less material is involved it is substantially quicker than forming the moat entirely by etching. The laser beam can be aimed very accurately resulting in improved positioning of the moat. Because of the small amount of surface damage caused by the laser beam it is preferred not to cut the moat directly to its final dimensions. The width of the cut moat is determined by the width of the laser beam and can therefore be varied by adjustment of the focus of the beam. Also the beam may be passed over the path of the moat more than once with small lateral displacement in order to widen the initial cut.

Subject to the dimensions of a finished diode relative to those of a raw semiconductor slice a plurality of diodes may be formed on a single device arranged as shown in the plan view of Fig. 3, in which seven diodes 10-16 are formed on a slice 17 and the positions of the moats surrounding the active region of each device are indicated by dashed lines as at 18. Eventually the slice 17 is broken up into individual pellets each of which conains one of the diodes. The edge chamfering technique of G.B. Patent No. 1 211 627 required the pellets to be separated before the chamfering stage. Now according to the invention he edge profiles are produced while the pellets still form part of the slice which produces consequent advantageous aspects in the handling of the devices for subsequent processing stages.

The proposed method of manufacturing passivated semiconductor devices according to the invention involves, at the moat forming stage, covering a semiconductor slice, such as 17 in Fig. 3, with a layer of conventional photoresist material, and cutting through the photoresist layer and into the slice using a laser beam moving transversely relative to the slice surface along the paths indicated by dashed lines 18 to trace out the moats. A Neodymium doped Yttrium Aluminium Garnet laser operating at 1.06 µm is suitable for this purpose.

Preferably the uncut slice is mounted horizontally on a table movable about horizontal X and Y axes relative to a laser beam aimed obliquely with respect to the vertical or Z axis. Alternatively the semiconductor slice may be held stationary and the laser assembly moved to trace out the moat path or paths or the laser beam may be optically manipulated to the same effect while the laser source is also stationary.

Subsequently the laser cut slices are etched in a solution containing a mixture of Nitric ($HNO_3$) and Hydrofluoric (HF) acids to which glacial acetic acid ($CH_3COOH$) may be added. A suitable mixture comprises, for example, 3 parts $HNO_3$: 1 part HF: 1 part $CH_3COOH$. Following this a conventional passivant such as glass, a chemical vapour deposited film, resin or rubber is applied. A low pressure chemical deposited film passivant is particularly suitable as this can be deposited evenly over irregular surfaces.

All types of high voltage power semiconductor devices can be handled; as mentioned above Figs. 1, 2 and 3 illustrate semiconductor diodes. Fig. 4 of the accompanying drawings shows a thyristor 20 having four superimposed layers of alternating conductivity type $N^+$, $P^+$, $N^-$ and $P^+$ in which a first obliquely angled moat 21 is cut and etched from the upper cathode surface 22 to passivate the junction generally indicated at 23. A similar second obliquely angled moat 24 is cut from he lower anode surface 25 to passivate the junction generally indicated at 26.

Fig. 5 shows a section through a thyristor 30 in which the reverse blocking junction is internally shorted to the forward blocking junction. In order to passivate both junctions 23 and 25 in this configuration a moat 27 of substantially inverted V section is cut into the top surface. Effectively this is a combination of the moats 21 and 24 (Fig. 4) cut using the same surface entrance slot.

The invention may also be applied to triacs in a manner similar to that illustrated in Figs. 4 and 5 and to transistors in the manner illustrated in Figs. 1 to 3.

The final stages of manufacture e.g. metallisation, pellet dicing and encapsulation are carried out in the normal way.

# 0070692

CLAIMS

1. A method of semiconductor device passivation in which a moat (5/6) adjacent the perimeter of the active region (10-16) of the device is coated with passivating dielectric material characterised by a step of forming the moat (5/6) by cutting by means of a laser beam incident at an oblique angle with respect to the surface of an active region of the device.

2. A method according to Claim 1 characterised by the further step of enlarging the laser cut moat (5/6) by chemical etching to the required dimensions of breadth and depth.

3. A method according to Claim 1 or Claim 2 wherein the semiconuctor device is moved transversely with respect to a relatively stationary laser beam to trace the path of the moat on the device.

4. A method according to Claim 1 or Claim 2 wherein the laser beam is moved transversely with respect to a relatively stationary semiconductor device to trace the path of the moat on the device.

5. A semiconductor device comprising three superimposed layers of alternating conductivity having a passivation moat formed by a method according to any preceding claim.

6. A thyristor type semicondutor device comprising four superimposed layers of alternating conductivity and having a reverse blocking junction internally shorted to a forward blocking junction, wherein both junctions are passivated by a moat of inverted, substantially V shaped section and each arm of the moat is formed by a method according to any one of Claims 1 to 4.

7. A semiconductor slice comprising a plurality of semiconductor devices (10-16) formed thereon each having a passivation moat formed by a method according to any one of Claims 1 to 4.

FIG.1

FIG.3

FIG.2

FIG.4

FIG.5